# FASCICULE DE BREVET EUROPEEN

(11) **EP 4 160 911 B1**
(45) Date de publication et mention de la délivrance du brevet: **15.04.2026**
(21) Numéro de dépôt: 21200072.3
(22) Date de dépôt: 30.09.2021
(51) Int. Cl.: H03D 11/04, H03D 11/08, H03B 5/12

(54) **PROCEDE POUR AMELIORER LE DEMARRAGE D'UN OSCILLATEUR D'UN RECEPTEUR A SUPER REACTION, ET RECEPTEUR POUR LA MISE EN OEUVRE DU PROCEDE**
VERFAHREN ZUR VERBESSERUNG DES STARTVORGANGS EINES OSZILLATORS EINES SUPERREAKTIONS-EMPFÄNGERS UND EMPFÄNGER ZUR DURCHFÜHRUNG DIESES VERFAHRENS
METHOD FOR IMPROVING THE STARTING OF AN OSCILLATOR OF A SUPER REACTION RECEIVER, AND RECEIVER FOR IMPLEMENTING SAID METHOD

(43) Date de publication de la demande: 05.04.2023
(73) Titulaire: The Swatch Group Research and Development Ltd, 2074 Marin (CH)
(72) Inventeur: AREND, Jean-Luc, 2035 Corcelles (CH); CASAGRANDE, Arnaud, 2014 Bôle (CH)
(74) Mandataire: ICB SA

(56) Documents cités:
- GB-A- 2 433 365
- US-A1- 2010 237 935
- PATRICK FAVRE ET AL: "A 2-V 600-A 1-GHz BiCMOS Super-Regenerative Receiver for ISM Applications", IEEE JOURNAL OF SOLID-STATE CIRCUITS, IEEE, USA, vol. 33, no. 12, 31 December 1998 (1998-12-31), XP011060882, ISSN: 0018-9200

## Description

### DOMAINE TECHNIQUE DE L'INVENTION

L'invention concerne un procédé pour améliorer la détection du temps de démarrage de l'oscillateur d'un récepteur à super réaction, ainsi que le récepteur pour la mise en œuvre du procédé.

### ETAT DE LA TECHNIQUE

Il est connu depuis les années 1920 et inventé par Edwin Howard Armstrong, un récepteur à ondes courtes, qui comprend également initialement trois lampes, qui coûtent cher et son invention a permis de réduire le fonctionnement du récepteur à une lampe. Comme discuté par la suite, ce principe est repris par la présente invention du récepteur à super réaction pour réduire la consommation électrique et simplifier l'architecture dudit récepteur.

Dans le brevet déposé en son nom US 1,342,885 A, il est décrit un procédé de réception des oscillations à haute fréquence par un récepteur à ondes courtes.

Dans un récepteur à super réaction, un oscillateur par exemple du type VCO du type LC peut être utilisé. Ce type d'oscillateur LC débute à osciller lorsque les pertes du résonateur de L et C sont compensées avec la conductance négative de dispositifs actifs. Cette limite correspond à un courant minimum aussi appelé courant critique de l'oscillateur qui est nécessaire pour démarrer l'oscillation.

Dans un récepteur à super réaction, le signal RF est directement injecté à la bobine résonnante de l'oscillateur. Selon la fréquence proche ou pas de la fréquence de résonance de l'oscillateur, et l'amplitude du signal RF, l'oscillateur démarre avec plus ou moins de courant et plus ou moins de temps. Ce courant de démarrage et le temps de démarrage associé sont détectés.

Pour quantifier ce courant de démarrage et le temps de démarrage associé, l'oscillateur est déclenché. Un courant en accroissement est injecté dans l'oscillateur. Ce courant débute en dessous du courant critique et augmente jusqu'au démarrage de l'oscillateur. Le courant peut avoir par exemple la forme d'une rampe linéaire. L'oscillateur débute à osciller à un courant donné correspondant à un temps de démarrage.

La demande de brevet US 5,613,231 A décrit un oscillateur muni d'un composant actif ou amplificateur et un composant réactif de stabilisation. Le composant actif est un transistor bipolaire disposé dans un circuit à base commune, alors que le composant réactif est un résonateur diélectrique entièrement couplé au collecteur du transistor. La base du transistor bipolaire est connectée à un pôle d'une alimentation par l'intermédiaire d'une première résistance et à un point commun par l'intermédiaire d'une seconde résistance et dont l'émetteur est connecté au même pôle par une troisième résistance. Un noyau résonateur est connecté entre le collecteur du transistor bipolaire et le point commun. Rien n'est décrit concernant l'amélioration du temps de démarrage d'un l'oscillateur d'un récepteur à super réaction.

Il est encore à noter qu'il est difficile de détecter ou déterminer exactement le temps de démarrage de l'oscillateur de référence parce que l'amplitude d'oscillation est généralement faible au démarrage typiquement en dessous de 100 mV. De plus, des circuits de détection d'amplitude typiques en technologie CMOS ne sont pas très sensibles pour les amplitudes en dessous de 100 mV.

La demande de brevet US 2010/237935 A1 décrit un détecteur logarithmique comprenant un élément amplificateur, des moyens pour régler une fréquence de fonctionnement du détecteur ; et un contrôleur, dans lequel un signal d'entrée vers l'élément amplificateur est agencé pour provoquer une oscillation dans l'élément amplificateur. Le contrôleur est utilisable pour détecter un seuil prédéterminé, indicatif d'une oscillation et, en réponse à la détection du seuil, pour interrompre l'oscillation de l'amplificateur pour que la fréquence de l'interruption soit proportionnelle au logarithme de la puissance du signal d'entrée. Il n'est pas décrit de récepteur à super réaction.

Il est cité l'article de Patrick Favre et AL : "A 2-V 600-A 1-GHz BiCMOS Super-Regenerative Receiver for ISM Applications", IEEE JOURNAL OF SOLID-STATE CIRCUITS, IEEE, USA, vol. 33, no. 12, 1 décembre 1998, XP011060882, ISSN : 0018-9200. Il est décrit un récepteur à super réaction, qui comprend un générateur de courant de polarisation pour fournir un courant de polarisation à un oscillateur de référence dès la réception d'un premier signal de commande d'activation, un détecteur d'oscillation connecté entre une entrée et une sortie de l'oscillateur de référence et le générateur de courant de polarisation pour détecter une oscillation dans l'oscillateur de référence. Il est également prévu un circuit de génération de courant d'amplification supplémentaire pour fournir un courant d'amplification supplémentaire à l'oscillateur de référence en plus du courant de polarisation traditionnel. Ce courant d'amplification supplémentaire est fourni à l'oscillateur de référence en plus du courant de polarisation traditionnel pour amplifier le signal d'oscillation afin d'être au-dessus d'un seuil critique de début d'oscillation pour définir le temps de démarrage de l'oscillateur et jusqu'à permettre au détecteur de commander l'arrêt de l'oscillateur de référence. Cependant il n'est pas prévu une augmentation progressive du courant de polarisation pour mieux définir le temps de démarrage, ce qui constitue un inconvénient.

La demande de brevet GB 2 433 365 A décrit un récepteur à super réaction qui comprend un oscillateur de référence alimenté par des courants de polarisation dès l'activation de l'oscillateur et un contrôleur de largeurs d'impulsions. L'oscillateur reste actif jusqu'à un certain niveau d'oscillation avant d'être désactivé. Il n'est pas effectué d'augmentation progressive du courant de polarisation pour mieux définir le temps de démarrage, ce qui constitue un inconvénient.

### RESUMÉ DE L'INVENTION

L'invention a donc pour but de fournir un procédé pour améliorer la détection du démarrage d'un oscillateur d'un récepteur à super réaction pour recevoir un ou plusieurs signaux RF, en palliant les inconvénients susmentionnés de l'état de la technique tout en permettant de réduire la consommation électrique pour son fonctionnement. De plus, le récepteur est à même de mettre en œuvre le procédé d'amélioration du démarrage de l'oscillateur du récepteur.

A cet effet, l'invention concerne un procédé pour améliorer le démarrage d'un oscillateur d'un récepteur à super réaction, qui comprend les caractéristiques définies dans la revendication indépendante 1.

Des étapes particulières du procédé sont définies dans les revendications dépendantes 2 à 5.

Un avantage du procédé pour améliorer la détection du démarrage d'un oscillateur d'un récepteur à super réaction réside dans le fait qu'il permet de fournir une meilleure transition entre l'état inactif et actif de l'oscillateur du récepteur autour d'un temps de démarrage bien déterminé, qui est proportionnel à l'amplitude et fréquence du signal RF capté. Pour ce faire suite à un courant de polarisation croissant et notamment au passage d'un premier seuil de tension faible correspondant à un courant critique de polarisation du début de l'oscillation, il est fourni à l'oscillateur en plus un courant supplémentaire d'amplification et ceci au moins dès le début de l'oscillation détectée. Cela permet également de déterminer exactement le temps de démarrage de l'oscillateur, car sans ce courant supplémentaire d'amplification (défini comme courant "boost" en terminologie anglaise), cela rend difficile de déterminer précisément ce temps de démarrage, qui est dépendant du signal RF capté.

Avantageusement, une fois que l'oscillation est détectée, il peut être envisagé de couper le courant de polarisation ainsi que le courant supplémentaire d'amplification dans le but de réduire la consommation électrique du récepteur. Plusieurs cycles successifs espacés dans le temps de fourniture de courant de polarisation provenant d'un générateur de courant de polarisation sont généralement prévus, permettant de mesurer à intervalles réguliers l'évolution du signal RF.

Avantageusement, il est prévu un circuit de génération d'un courant d'amplification en plus du générateur de courant de polarisation de l'oscillateur. Ce circuit de génération de courant d'amplification peut être adapté pour fournir un courant d'amplification supplémentaire à l'oscillateur dès le début de l'oscillation détectée au niveau du premier seuil de tension bas. Grâce à cela, cela permet de rapidement couper le courant de polarisation et le courant d'amplification supplémentaire pour l'oscillateur dès la détection de l'oscillation pour réduire la consommation électrique du circuit récepteur. Ce courant d'amplification peut être constant au-dessus du seuil de tension bas, pour fournir rapidement un courant supplémentaire d'amplification pour bien déterminer le temps de démarrage de l'oscillation de l'oscillateur sans être influencé par d'éventuels bruits de variation d'amplitude du signal de l'oscillateur.

L'oscillateur de référence du récepteur est de préférence un oscillateur du type VCO à fonctionnement à haute fréquence correspondant à la fréquence d'un signal RF capté par le récepteur. Pour la réduction de consommation, l'oscillateur de référence doit en principe être arrêté juste après la détermination du temps de démarrage de l'oscillation de l'oscillateur. Cet oscillateur du type VCO est de préférence un oscillateur LC composé principalement d'une inductance et d'un condensateur en parallèle.

Avantageusement, le signal RF externe, qui est collecté par l'antenne du récepteur, est directement amené sur le circuit résonant de l'oscillateur, créant ainsi une condition d'oscillation initiale plus ou moins favorable au démarrage plus ou moins rapide de l'oscillateur. De plus, le temps de démarrage déterminé par la suite est directement dépendant du signal RF capté.

A cet effet, l'invention concerne également un récepteur à super réaction pour la mise en œuvre du procédé, qui comprend les caractéristiques définies dans la revendication indépendante 6.

Des formes particulières du récepteur sont définies dans les revendications dépendantes 7 à 11.

### BRÈVE DESCRIPTION DES FIGURES

Les buts, avantages et caractéristiques du procédé pour améliorer le démarrage d'un oscillateur de référence d'un récepteur à super réaction apparaîtront mieux dans la description suivante sur la base de formes d'exécution non limitatives et illustrées par les dessins sur lesquels :

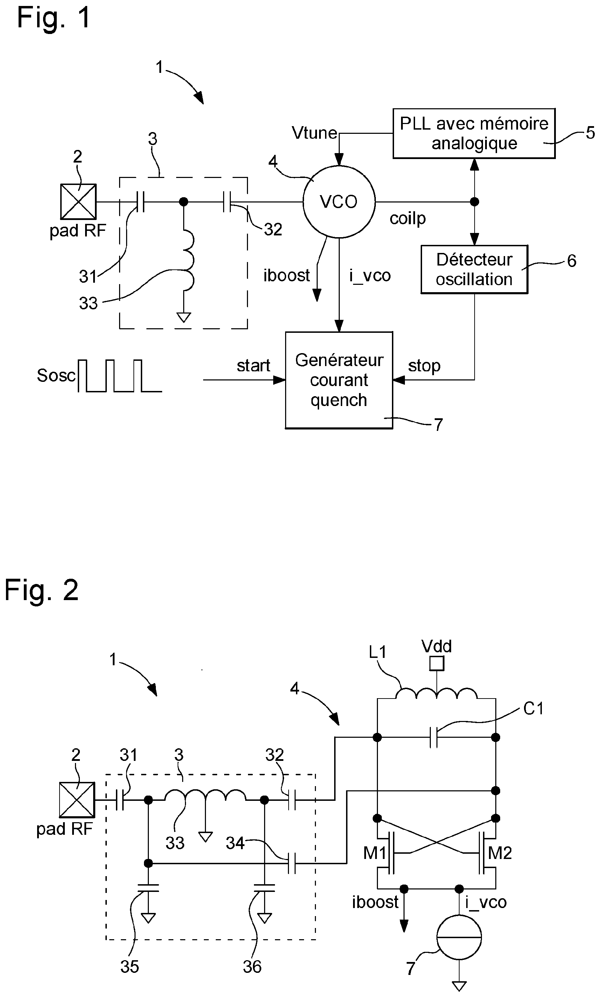

- la figure 1 représente de manière simplifiée une première forme d'exécution d'un récepteur à super réaction avec un ensemble de composants électroniques pour détecter la présence d'un signal RF à l'entrée et améliorer la détection du démarrage de l'oscillation de l'oscillateur selon la présente invention,
- la figure 2 représente une seconde forme d'exécution simplifiée du récepteur de signaux RF adaptée pour améliorer la détection du temps de démarrage d'un oscillateur de référence tel qu'un VCO adapté en tension et avec un courant de polarisation pour la génération d'une oscillation de l'oscillateur et d'un courant supplémentaire d'amplification selon la présente invention,

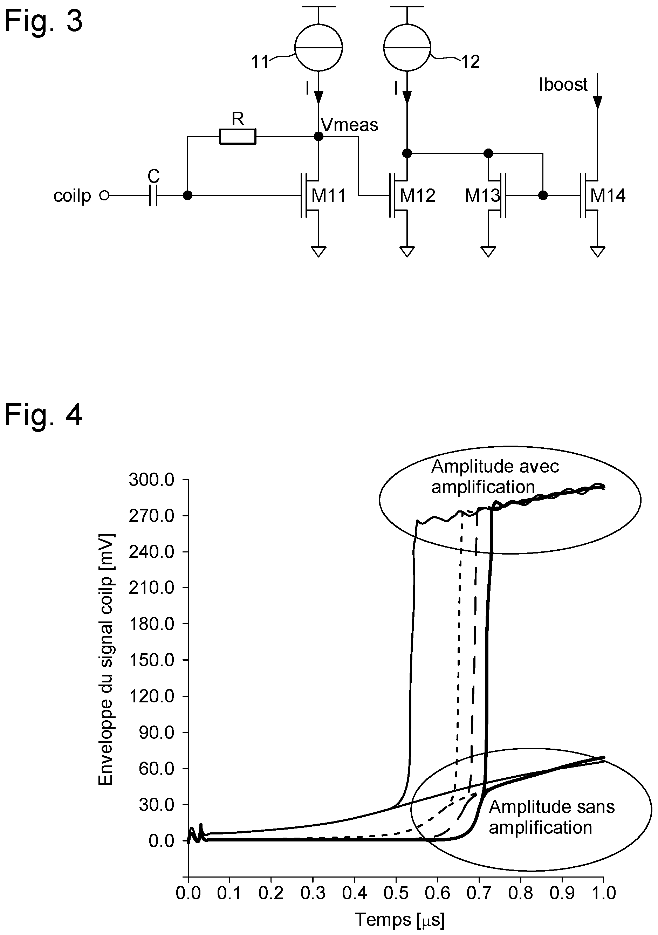

- la figure 3 représente une forme d'exécution simplifiée d'un circuit de génération d'un courant d'amplification supplémentaire à fournir de préférence à l'oscillateur au début de l'oscillation pour le récepteur à super réaction, et où l'entrée de ce circuit est directement connectée à un terminal de sortie de l'oscillateur de référence représenté aux figures 1 et 2,
- la figure 4 représente l'évolution temporelle de l'amplitude du signal de sortie de l'oscillateur de référence au démarrage pour différentes amplitudes du signal RF présent sur le pad RF d'entrée représenté aux figures 1 et 2 et montrant la différence avec ou sans l'ajout d'un courant d'amplification supplémentaire au moment de l'activation du récepteur et du générateur de courant de polarisation, et

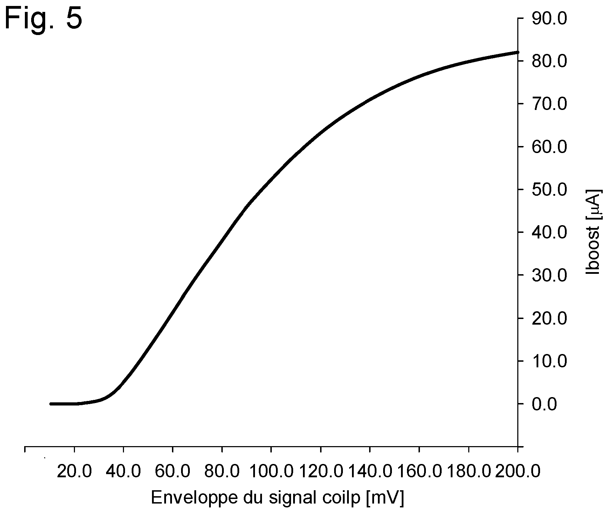

- la figure 5 représente le courant d'amplification supplémentaire pour l'oscillateur VCO en fonction de l'amplitude du signal de sortie, où ce courant augmente rapidement au-delà d'une certaine amplitude du signal de sortie, ce qui permet d'augmenter notablement la croissance du signal de sortie par réaction positive, et cette croissance d'amplitude plus rapide permettant de détecter plus facilement le temps de démarrage de l'oscillation de l'oscillateur.

### DESCRIPTION DETAILLEE DE L'INVENTION

Dans la description suivante, il est fait référence à un procédé pour améliorer la précision de la détection de démarrage de l'oscillateur d'un récepteur à super réaction avec une réduction de la consommation électrique. Bien entendu tous les composants utilisés dans le récepteur, qui sont bien connus dans le domaine technique, ne seront relatés que de manière simplifiée. Il est fait principalement référence à l'amélioration de la précision de détection du démarrage de l'oscillateur de référence, qui peut être un oscillateur VCO par exemple de type LC.

La figure 1 représente de manière complète une première forme d'exécution d'un récepteur 1 de signaux RF agencé pour améliorer la précision de la détection du temps de démarrage d'un oscillateur de référence 4 notamment suite à la détection de réception d'au moins un signal RF. Le temps de démarrage dépend directement du signal RF capté par le récepteur. Pour ce faire, le récepteur 1 comprend tout d'abord une borne ou pad 2 d'entrée de réception d'un signal RF. Le récepteur 1 comprend un oscillateur de référence 4 pour la génération d'une oscillation dans l'oscillateur, un générateur de courant de polarisation 7 pour fournir un courant de polarisation i_vco à l'oscillateur de référence 4. Le courant de polarisation i_vco est fourni à l'oscillateur de référence 4 notamment suite à la réception d'au moins un signal de commande d'activation, c'est-à-dire de début (start). De préférence, il est prévu un cycle de signaux de commande d'activation Sosc espacés dans le temps pour le générateur de courant de polarisation 7.

Le récepteur à super réaction 1 comprend encore un détecteur d'oscillation 6, qui est connecté entre une sortie coilp de l'oscillateur de référence 4 et le générateur de courant de polarisation 7 de manière à commander le générateur 7 notamment après qu'un signal RF est reçu par le récepteur 1, et qu'une oscillation de l'oscillateur est détectée. Une unité d'adaptation d'impédances 3 du récepteur 1 est disposée entre la borne ou pad 2 de réception du récepteur 1 et l'oscillateur de référence 4.

Le récepteur 1 comprend encore un circuit de génération d'un courant d'amplification supplémentaire iboost non représenté à la figure 1. Le courant d'amplification supplémentaire iboost est fourni en plus au courant de polarisation i_vco à l'oscillateur pour améliorer la détection du temps de démarrage de l'oscillateur. Le courant d'amplification supplémentaire iboost est généré et fourni à l'oscillateur de préférence dès la détection d'une première oscillation de l'oscillateur de manière à arrêter l'oscillateur dès le début de l'oscillation dans l'oscillateur de référence 4 mais au moins après la fourniture de ce courant d'amplification supplémentaire iboost. Cela permet également de bien définir le temps de démarrage de l'oscillation de l'oscillateur de référence 4 comme le courant d'amplification supplémentaire iboost est de plus grande valeur de préférence que le courant de polarisation i_vco. Après la fourniture de ce courant d'amplification supplémentaire iboost et en ayant détecté l'oscillation de l'oscillateur, une coupure rapide du courant de polarisation i_vco et du courant d'amplification supplémentaire iboost intervient. Cela permet de réduire directement et rapidement la consommation électrique par rapport à un récepteur traditionnel. Il est à noter que le circuit de génération de courant d'amplification supplémentaire peut être activé dès la première détection d'oscillation de l'oscillateur par le détecteur d'oscillation. Une fois que le courant d'amplification supplémentaire a été fourni à l'oscillateur de référence, le temps de démarrage est bien défini et l'oscillation est bien établie. Cela permet de commander l'arrêt complet de l'oscillateur notamment en désactivant le générateur de courant de polarisation, ainsi que le circuit de génération de courant d'amplification supplémentaire.

Ce temps de démarrage est fonction d'au moins un signal RF capté par le récepteur. Toute information liée au signal RF reçu permet de déterminer précisément le temps de démarrage.

Il est à noter que le circuit de génération de courant d'amplification supplémentaire peut être activé dès la première détection d'oscillation de l'oscillateur par le détecteur d'oscillation 6. Une fois que le courant d'amplification supplémentaire a été fourni à l'oscillateur de référence 4, le temps de démarrage est bien défini et l'oscillation est bien établie. Cela permet de commander l'arrêt complet de l'oscillateur notamment en désactivant le générateur de courant de polarisation 7, ainsi que le circuit de génération de courant d'amplification supplémentaire.

Bien entendu pour le récepteur à super réaction 1, il doit être prévu dans le récepteur une unité de traitement de tous les signaux, qui peut comprendre un processeur cadencé par un autre oscillateur ou un microprocesseur. Des signaux de contrôle des différents composants électroniques du récepteur peuvent être transmis par l'unité de traitement non représentée. L'unité de traitement peut prendre en compte la réception d'un premier signal RF pour commander l'activation du générateur de courant de polarisation. L'unité de traitement peut servir également à la fourniture d'au moins un signal de commande d'activation pour activer le générateur de courant de polarisation 7 et également pour l'activation du circuit de génération de courant d'amplification supplémentaire iboost dès le début d'une oscillation détectée.

Dans le cycle des signaux de commande d'activation Sosc, il y a tout d'abord un premier signal de commande start pour la fourniture d'une commande de polarisation de l'oscillateur de référence 4. Dès cet instant, suite au signal de commande d'activation start du générateur de courant de polarisation 7, le courant de polarisation i_vco croît par exemple linéairement jusqu'à obtenir une valeur critique du courant de polarisation à partir de laquelle l'oscillateur de référence 4 peut commencer à osciller par exemple à une haute fréquence de l'ordre de 2,4 GHz. C'est l'enveloppe de ce signal à haute fréquence, qui peut être prise en compte pour la détection d'oscillation. Dès cet instant d'oscillation de l'oscillateur de référence 4, une détection est effectuée dans le détecteur d'oscillation 6, qui est relié au moins au générateur de courant de polarisation 7, ainsi qu'au circuit de génération de courant d'amplification supplémentaire iboost soit directement, soit par l'intermédiaire du générateur de courant de polarisation 7. Une fois que la détection d'oscillation est effectuée et après la fourniture du courant d'amplification supplémentaire iboost, un signal d'arrêt stop est fourni au générateur de courant de polarisation 7, ainsi qu'au circuit de génération de courant d'amplification supplémentaire pour arrêter immédiatement l'oscillation de l'oscillateur de référence 4. C'est le but recherché par la présente invention, d'arrêter ainsi complètement la fourniture du courant de polarisation et du courant amplification supplémentaire fournis à l'oscillateur de référence 4 dès la détection de l'oscillation de l'oscillateur de référence 4. Une réduction de consommation électrique est ainsi obtenue en arrêtant immédiatement la fourniture des courants de polarisation i_vco et d'amplification supplémentaire iboost à l'oscillateur 4 une fois que l'oscillation a été détectée. L'oscillateur s'arrête immédiatement d'osciller après la commande d'arrêt stop fournie par le détecteur d'oscillation 6 au générateur de courant de polarisation 7 et au circuit de génération de courant d'amplification supplémentaire discuté en référence à la figure 3 suivante.

Dans une situation classique, l'enveloppe du signal haute fréquence créé par l'oscillateur croît de manière lente au démarrage suite à la fourniture du courant de polarisation i_vco, et il devient délicat de détecter précisément le temps de démarrage en observant l'enveloppe du signal haute fréquence, car une légère modification de la tension d'enveloppe détectée au voisinage d'un seuil donné peut facilement être induite par le bruit ambiant (bruit présent dans tous les composants actifs de l'oscillateur et du détecteur d'amplitude).

Selon la présente invention, il peut être prévu de générer un courant d'amplification supplémentaire iboost dépendant de l'enveloppe détectée et d'envoyer ce courant directement sur la polarisation de l'oscillateur avec le courant de polarisation i_vco, créant ainsi une réaction positive. Cette réaction positive permet à l'oscillateur d'augmenter rapidement l'enveloppe du signal oscillant (dès qu'un signal oscillant commence à exister) et de faire transiter ainsi le signal de détection d'enveloppe beaucoup plus rapidement et avec une pente beaucoup plus marquée au travers d'un seuil donné correspondant au seuil du courant critique de début d'oscillation.

Le détecteur d'oscillation 6 va prendre en compte la détection d'oscillation suite à la fourniture du courant d'amplification supplémentaire iboost pour lequel l'enveloppe du second signal d'oscillation est bien au-dessus du seuil de début d'oscillation. Suite à cette détection par le détecteur d'oscillation 6 avec un temps de démarrage bien défini, un signal d'arrêt est transmis au générateur de courant de polarisation 7 ainsi qu'au circuit de génération du courant d'amplification supplémentaire iboost. Pour le détecteur d'oscillation 6, il peut être prévu une première détection d'oscillation pour permettre au circuit de génération de courant d'amplification supplémentaire d'être activé et de fournir le courant d'amplification supplémentaire à l'oscillateur. Finalement, le détecteur d'oscillation fournit un signal de commande d'arrêt après la seconde détection d'oscillation avec amplification du signal oscillant.

Comme expliqué ci-après en référence à la figure 3, le circuit de génération de courant d'amplification supplémentaire peut selon une variante de réalisation être intégré dans le générateur de courant de polarisation 7. Cependant il peut aussi être prévu d'avoir un circuit de génération de courant d'amplification supplémentaire à l'extérieur du générateur de courant de polarisation. Dans ces conditions, le circuit de génération de courant amplification supplémentaire peut être contrôlé par le détecteur d'oscillation 6 directement pour la fourniture du courant d'amplification supplémentaire iboost notamment dès le début de l'oscillation détectée.

De préférence, l'oscillateur de référence 4 est un oscillateur VCO commandé en tension du type LC, qui comprend en parallèle au moins une inductance L1 et un condensateur C1. Dans la configuration présentée à la figure 1, l'inductance L1 est séparée en deux inductances liées l'une à l'autre et dont la liaison des deux parties d'inductance est alimentée par une tension d'adaptation Vdd. L'inductance définit un circuit oscillant, dont la fréquence de résonance est ajustée à l'aide d'une capacité variable (non représentée sur la figure 2), qui est contrôlée par une tension Vtune. Pour ce faire, le récepteur 1 comprend encore une boucle à verrouillage de phase PLL 5 dépendante d'une référence de fréquence externe (non représentée sur la figure 1) et reliée entre la sortie coilp de l'oscillateur VCO 4 et la tension de contrôle de la capacité variable (Vtune). La tension d'adaptation Vtune en sortie de la boucle PLL 5 est une tension de commande de la fréquence d'oscillation de l'oscillateur VCO commandé en tension 4. La boucle PLL 5 peut comprendre une mémoire analogique pour mémoriser la tension Vtune. Bien entendu, comme l'oscillateur agit en différentiel, il peut aussi être utilisé la borne de sortie non représentée coiln en lieu et place de la borne de sortie coilp de l'oscillateur de référence 4. Dans ce cas comme représenté à la figure 2, la borne coiln non représentée est l'entrée de l'oscillateur de référence 4 reliée par l'unité d'adaptation d'impédances 3 à la borne ou pad 2 du récepteur 1 de signaux RF.

Comme représenté à figure 1, l'unité d'adaptation d'impédances 3 permet d'adapter le signal radiofréquence RF reçu par le récepteur 1 avant d'entrer dans l'oscillateur de référence 4 qui est de préférence un oscillateur VCO. Cette unité d'adaptation d'impédances 3 comprend tout d'abord un premier condensateur 31 relié d'une part à la borne ou pad 2 d'entrée du signal RF et d'autre part relié à un second condensateur 32 dont l'autre extrémité est reliée à l'entrée de l'oscillateur de référence 4 qui est l'oscillateur. VCO. L'unité d'adaptation d'impédances 3 comprend encore une inductance 33, qui est d'une part reliée à la liaison des deux condensateurs 31, 32 et d'autre part à la masse.

La figure 3 représente une forme d'exécution du circuit de génération de courant d'amplification supplémentaire iboost à fournir à l'oscillateur de référence 4, qui peut être un oscillateur VCO en complément à un courant de polarisation dans un mode de fonctionnement de l'oscillateur. De préférence, le circuit de génération de courant d'amplification supplémentaire iboost comprend un premier étage de détection M11, M12 relié à un miroir de courant M13, M14 pour la fourniture du courant d'amplification supplémentaire iboost pour l'oscillateur. Comme décrit plus loin, un tel circuit de génération de courant d'amplification supplémentaire peut être encore plus simple que ce qui est déjà présenté sur cette figure 3.

Les différents étages M11, M12 et M13, M14 sont composés par exemple de transistors en technologie CMOS. Dans la configuration présentée à la figure 3, le premier étage de détection M11, M12 est composé de deux transistors NMOS M11, M12. Ces deux transistors M11, M12 sont par exemple deux transistors NMOS identiques de même taille polarisés en faible inversion. Le miroir de courant M13, M14 est composé de deux transistors NMOS M13, M14. Ces deux transistors M13, M14 sont par exemple deux transistors NMOS polarisés en forte inversion.

Le premier transistor M11 du premier étage de détection a une borne de grille reliée au signal coilp de l'oscillateur 4 de la figure 1 par l'intermédiaire d'un condensateur d'entrée C. La borne de source du premier transistor M11 du premier étage de détection est reliée à la borne de masse à 0 V, alors que la borne de drain du transistor M11 est reliée par l'intermédiaire d'une résistance d'entrée R à sa borne de grille et à une première source de courant 11 reliée à une borne de tension d'alimentation Vdd et fournissant un courant I pour le premier transistor M11. Au moment de l'enclenchement du récepteur et du générateur de courant de polarisation, comme le courant de polarisation est relativement faible, la tension augmente très gentiment avant d'atteindre le seuil critique pour que l'oscillation débute dans l'oscillateur.

Le courant de la première source de courant 11 polarise le transistor NMOS M11 dans un mode de détection d'amplitude non linéaire, et la tension Vmeas décroît à mesure que l'amplitude du signal oscillant coilb augmente. La borne de grille du transistor NMOS M12 est connectée à cette tension Vmeas et a pour effet de détourner entièrement le courant de la seconde source de courant 12 (légèrement plus faible que la source 11) vers la masse. Lorsque l'amplitude du signal coilb augmente, la tension Vmeas détectée diminue et le courant de la source 12 est progressivement envoyé dans le miroir de courant constitué par les transistors NMOS M13, M14 qui détermine alors un courant Iboost croissant De préférence, la source de courant 11 est ajustée pour fournir un courant légèrement supérieur à celle de la source 12. Pour contrôler le miroir de courant M13, M14, la borne de drain du second transistor NMOS M12 du détecteur d'amplitude est reliée à la borne de drain et à la borne de grille du premier transistor NMOS M13 du miroir de courant, alors que la borne de source du premier transistor NMOS M13 du miroir de courant est reliée à la masse à 0 V. Le second transistor NMOS M14 du miroir de courant a sa borne de grille reliée à la borne de grille et à la borne de drain du premier transistor NMOS M13 du miroir de courant. La borne de source du second transistor NMOS M14 est reliée à la masse à 0 V, alors que la borne de drain du second transistor M14 du miroir de courant fournit le courant d'amplification supplémentaire iboost pour l'oscillateur de référence.

Il peut être envisagé d'autres formes d'exécution du circuit de génération de courant d'amplification supplémentaire en prenant exemple sur la forme d'exécution décrite ci-dessus en référence à la figure 3.

Pour pouvoir décrire le procédé d'amélioration du démarrage de l'oscillateur de référence du récepteur, il y a différents signaux pour la mise en fonction du récepteur 1 notamment dès la réception d'un signal RF, qui sont décrits sommairement. Il est précisé également que le récepteur à super réaction 1 est de préférence un récepteur de réveil (wake-up récepteur), qui doit être en fonction continuellement mais par périodes très courtes dans le temps comme défini dans le cycle des signaux de commande Sosc décrits à la figure 1, qui sont plusieurs signaux de commande successifs de début start fournis dans le temps au générateur de courant de polarisation 7 pour l'enclencher ou l'activer.

Dans le cas d'un oscillateur VCO qui est du type LC. Cet oscillateur est prévu pour être souvent dans un état déclenché et est agencé pour démarrer très souvent sur de courtes périodes et très rapidement à fonctionnement à haute fréquence par exemple à 2,4 GHz. On peut enclencher rapidement l'oscillateur VCO sur de courtes périodes pour réagir avec peu de composants sur des éléments clés de l'oscillation qui doit être rapidement débutée. Il est possible que le signal de commande d'activation Sosc (start) où l'oscillation démarre sur une période de 1 µs et que sur une seconde, il y a à peu près 1000 périodes de commande d'activation Sosc ou d'enclenchement de l'oscillateur VCO 4. Cela signifie que le récepteur 1 n'est enclenché totalement que pendant 1 ms sur une seconde, ce qui réduit fortement la consommation électrique et ce qui est recherché. Comme expliqué auparavant suite à un premier signal de commande de départ start fourni au générateur de courant de polarisation 7, une croissance linéaire de la valeur du courant de polarisation intervient jusqu'à atteindre une valeur critique du courant de polarisation, mais relativement lentement. Dès que le courant de valeur critique est atteint, l'oscillateur de référence VCO 4 commence à osciller, ce qui est directement détecté par le détecteur d'oscillation 6 qui transmet un signal de commande d'arrêt stop d'oscillation au générateur de courant de polarisation 7. L'oscillation de l'oscillateur de référence VCO est annulée, ce qui signifie qu'un signal RF a bien été détecté et tout en garantissant une réduction significative de consommation électrique du récepteur 1 par rapport à ce qui est connu dans l'état de la technique.

Bien entendu, la fréquence d'apparition de ces signaux de commande Sosc de début start pour le générateur de courant de polarisation 7, peut être modifié manuellement ou de manière automatique pour s'adapter aux conditions de l'oscillateur de référence 4.

Il est encore à noter dans un mode de centrage initial de fréquence, l'oscillateur VCO est démarré dans une boucle de ce type afin de déterminer une tension comme la tension Vtune correspondant à la fréquence de réception notamment dans un synthétiseur de fréquences traditionnel. Ensuite, la tension est mémorisée par un DAC et le synthétiseur est désactivé. L'oscillateur VCO 4 est éteint et le signal RF peut être envoyé par exemple au travers du réseau d'adaptation 3 sur le circuit oscillant de l'oscillateur VCO 4 afin de procéder à la démodulation par super réaction. La mesure du temps de démarrage du VCO est en présence d'une rampe de son courant de polarisation. Ainsi, il est possible de ne pas abaisser la fréquence pour la démodulation dans ce récepteur à super réaction.

Un tel synthétiseur de fréquence, qui comprend l'oscillateur VCO, a été décrit dans la demande de brevet EP 3 573 241 A1 en référence à la figure 4 dans la description. Si un tel synthétiseur de fréquences est utilisé pour le centrage de fréquences de l'oscillateur VCO de la présente invention, cette demande de brevet est incorporée ici par référence.

Le récepteur à super réaction sera encore décrit maintenant en référence à la figure 2 ou d'autres formes d'exécution.

La figure 2 représente une seconde forme d'exécution du récepteur en ne montrant que l'entrée 2 du récepteur, l'unité d'adaptation d'impédances 3 et l'oscillateur de référence 4 qui est ici un oscillateur VCO 4. Sur cette figure 2, il n'est pas représenté le détecteur d'oscillation et la boucle à verrouillage de phase PLL mais comme auparavant ils agissent à un même endroit du récepteur. L'oscillateur VCO est composé d'une première inductance L1 et d'un condensateur C1 relié en parallèle à l'inductance L1. Comme précédemment, l'inductance L1 est séparée en deux inductances liées l'une à l'autre et dont la liaison des deux parties d'inductance est alimentée par une tension d'alimentation Vdd. L'oscillateur VCO 4 comprend encore en dessous à une première extrémité de liaison de l'inductance L1 et du condensateur C1, un premier transistor M1, qui est de préférence un transistor MOS, par exemple dans cette configuration un transistor NMOS, et à une seconde extrémité de liaison de l'inductance L1 et du condensateur C1, un second transistor M2 du même type que le premier transistor, par exemple un transistor NMOS. La borne de drain du premier transistor M1 est reliée à la première extrémité de liaison de l'inductance L1 et du condensateur C1, alors que la borne de drain du second transistor M2 est reliée à la seconde extrémité de liaison de l'inductance L1 et du condensateur C1. La grille du premier transistor M1 est reliée au drain du second transistor M2, alors que la grille du second transistor M2 est reliée au drain du premier transistor M1. Les deux sources des deux transistors M1 et M2 sont reliées pour recevoir le courant de polarisation du générateur de courant de polarisation 7. La sortie coilp de l'oscillateur VCO peut être fourni par le drain du second transistor M2.

L'unité d'adaptation d'impédances 3 comprend un premier condensateur 31 relié d'un premier côté à la borne ou pad 2 d'entrée du récepteur 1, alors qu'un second côté du premier condensateur 31 est relié à une première extrémité d'une inductance additionnelle 33, dont une seconde extrémité de l'inductance additionnelle est reliée à un premier côté d'un second condensateur 32. L'inductance additionnelle 33 est séparée en deux inductances liées l'une à l'autre et dont la liaison des deux parties d'inductance peut être reliée à la masse. La liaison du premier condensateur 31 et de l'inductance additionnelle 33 est encore reliée à un premier côté d'un troisième condensateur 34 et à un premier côté d'un quatrième condensateur 35 dont le second côté est relié à la masse. Un premier côté d'un cinquième condensateur 36 est relié à la liaison du second condensateur 32 et de l'inductance additionnelle 33. Le second côté du cinquième condensateur 36 est relié à la masse.

Un second côté du second condensateur 32 est relié à la première extrémité de l'inductance L1 et du condensateur C1 et également à la grille du second transistor M2 et au drain du premier transistor M1. Un second côté du troisième condensateur 34 est relié à la seconde extrémité de l'inductance L1 et du condensateur C1 et également à la grille du premier transistor M1 et au drain du second transistor M2. La tension d'adaptation de fréquences peut être appliquée à la première extrémité ou à la seconde extrémité de connexion de l'inductance L1 avec le condensateur C1.

Comme précédemment indiqué, il peut être utilisé un oscillateur de référence 4 autre qu'un oscillateur VCO traditionnel pour autant qu'il puisse fonctionner à haute fréquence par exemple vers 2,4 GHz.

La figure 4 représente différentes valeurs de l'enveloppe coilp et ceci pour différentes valeurs d'amplitude du signal RF appliqué sur l'entrée du récepteur, et montrant la différence avec ou sans l'ajout d'un courant d'amplification supplémentaire au moment de l'activation du récepteur et du générateur de courant de polarisation. Comme on peut voir sur la figure 4, le signal s1 est celui représenté en continu et avec une valeur d'entrée du signal RF à -30dBm. Le signal s2 est celui représenté en pointillés serrés et avec une valeur d'entrée du signal RF à -40dBm. Le signal s3 est celui représenté en traits interrompus larges et avec une valeur d'entrée du signal RF à - 50dBm. Finalement, le signal s4 est celui représenté en continu gras et avec une valeur d'entrée du signal RF à -60dBm.

Sur cette figure 4, on voit bien la différence de l'application d'un courant d'amplification supplémentaire iboost dépendant de l'enveloppe d'amplitude du signal coilp, ajouté au courant de polarisation traditionnelle i_vco de manière à bien déterminer le temps de démarrage de l'oscillateur. L'ajout de ce courant d'amplification supplémentaire iboost permet d'obtenir une meilleure détection d'oscillation de l'oscillateur de référence 4. La tension sur les grilles des transistors M13, M14 du miroir de courant passe rapidement au-dessus de la tension de seuil. Cela permet d'obtenir plus rapidement l'oscillation de l'oscillateur pour détecter précisément le temps de démarrage de l'oscillateur détecté par le détecteur d'oscillation.

Différentes enveloppes du signal coilp sont représentés sur la figure 4, qui correspondent à différents niveaux du signal RF présent sur l'entrée du récepteur. On voit bien l'augmentation relativement faible de l'enveloppe du signal oscillant coilp si uniquement le courant de polarisation est fourni à l'oscillateur. Pour des raisons de bruit ambiant, la détection de transition de l'enveloppe de coilp au-dessus d'un seuil donné est difficile à détecter en utilisant uniquement le courant de polarisation. C'est pourquoi, un courant d'amplification supplémentaire est ajouté pour un démarrage plus rapide de l'oscillation de l'oscillateur et c'est ce qui est le cas pour les 4 signaux s1, s2, s3, s4 représentés avec ou sans amplification.

La figure 5 représente le courant d'amplification supplémentaire pour l'oscillateur VCO et également l'amplitude, qui augmente rapidement une fois qu'un seuil donné est atteint, cette amplitude plus grande permettant de détecter plus facilement le temps de démarrage de l'oscillation de l'oscillateur. Ceci est dû au feed-back positif, le courant d'amplification supplémentaire et aussi l'amplitude augmente rapidement une fois que le seuil est atteint. Cette amplitude plus grande permet de détecter plus facilement le temps de démarrage, ce qui est recherché.

A partir de la description qui vient d'être faite, plusieurs variantes du procédé d'amélioration de démarrage d'un oscillateur de référence d'un récepteur à super réaction peuvent être réalisées sans sortir du cadre défini par les revendications.

## Revendications

1. Procédé pour améliorer la détection du temps de démarrage d'un oscillateur de référence (4) d'un récepteur (1) à super réaction, le récepteur (1) comprenant l'oscillateur de référence (4), un générateur de courant de polarisation (7) pour fournir un courant de polarisation (i_vco) à l'oscillateur de référence (4) dès la réception d'au moins un signal de commande d'activation (Sosc), un détecteur d'oscillation (6) connecté entre une entrée ou une sortie (coilp) de l'oscillateur de référence (4) et le générateur de courant de polarisation (7) pour détecter une oscillation dans l'oscillateur de référence (4), et une unité d'adaptation d'impédances (3) disposée entre une borne ou pad (2) de réception d'un signal RF du récepteur (1) et l'oscillateur de référence (4),
suite à la fourniture du courant de polarisation (i_vco) après réception du signal de commande d'activation (Sosc), le détecteur d'oscillation (6) détecte une première oscillation de l'oscillateur de référence (4) et dès que l'oscillation est détectée, un courant d'amplification supplémentaire (iboost) dépendant de l'enveloppe de l'oscillation détectée par un circuit de génération de courant d'amplification est fourni à l'oscillateur de référence (4) en plus du courant de polarisation pour amplifier le signal d'oscillation pour être au-dessus d'un seuil critique de début d'oscillation de manière à définir précisément le temps de démarrage de l'oscillateur, à chaque signal de commande d'activation (Sosc) fourni au générateur de courant de polarisation (7), un courant de polarisation augmente progressivement jusqu'à atteindre au moins une valeur de courant critique à partir de laquelle l'oscillation de l'oscillateur de référence (4) débute, en ce que le détecteur d'oscillation (6) détecte la première oscillation de l'oscillateur de référence (4), et **caractérisé en ce qu'**à la seconde oscillation détectée par le détecteur d'oscillation (6) un signal de commande d'arrêt (stop) est fourni au générateur de courant de polarisation (7), ainsi qu'au circuit de génération de courant d'amplification supplémentaire pour couper immédiatement la fourniture des courants à l'oscillateur de référence (4) pour l'arrêter immédiatement et ainsi réduire la consommation électrique du récepteur.

2. Procédé selon la revendication 1, **caractérisé en ce que** le courant de polarisation (i_vco) est fourni à l'oscillateur de référence (4) notamment suite à la réception de chaque signal de commande d'activation (Sosc) dans le temps d'un cycle de signaux de commande d'activation (Sosc) du générateur de courant de polarisation (7).

3. Procédé selon la revendication 2, **caractérisé en ce que** le signal de commande d'activation (Sosc) démarre sur une période de 1 µs et que sur une seconde, on peut compter près de 1000 périodes de commande d'activation (Sosc) d'un cycle de signaux de commande successifs (Sosc) de telle manière que le récepteur (1) n'est enclenché totalement que pendant 1 ms sur une seconde.

4. Procédé selon l'une des revendications précédentes, pour lequel le récepteur (1) comprend encore une boucle PLL à verrouillage de phase (5), **caractérisé en ce que** dans le temps, une tension d'adaptation (Vtune) est fournie à l'oscillateur de référence, qui est un oscillateur VCO (4) pour l'adaptation de la fréquence d'oscillation.

5. Procédé selon l'une des revendications précédentes, **caractérisé en ce que** le générateur de courant de polarisation (7) est activé par au moins un signal de commande d'activation suite à la réception d'un signal RF.

6. Récepteur (1) à super réaction configuré pour la mise en œuvre du procédé pour améliorer la détection du temps de démarrage d'un oscillateur de référence (4) d'un récepteur (1) à super réaction selon l'une des revendications précédentes, le récepteur comprenant l'oscillateur de référence (4), un générateur de courant de polarisation (7) pour fournir un courant de polarisation (i_vco) à l'oscillateur de référence (4) dès la réception d'au moins un signal de commande d'activation (Sosc), un détecteur d'oscillation (6) connecté entre une entrée ou une sortie (coilp) de l'oscillateur de référence (4) et le générateur de courant de polarisation (7) pour détecter une oscillation dans l'oscillateur de référence (4), et une unité d'adaptation d'impédances (3) disposée entre une borne ou pad (2) de réception d'un signal RF du récepteur (1) et l'oscillateur de référence (4), le récepteur (1) comprenant un circuit de génération de courant d'amplification supplémentaire pour fournir un courant d'amplification supplémentaire (iboost) à l'oscillateur de référence (4) en plus au courant de polarisation après une première oscillation détectée par le détecteur d'oscillation (6), un courant d'amplification supplémentaire (iboost) étant fourni à l'oscillateur de référence (4) en plus du courant de polarisation pour amplifier le signal d'oscillation pour être au-dessus d'un seuil critique de début d'oscillation de manière à définir précisément le temps de démarrage de l'oscillateur, et permettre au détecteur d'oscillation (6) de commander l'arrêt de l'oscillateur de référence (4) au moment d'une seconde oscillation détectée par le détecteur d'oscillation (6).

7. Récepteur (1) à super réaction selon la revendication 6, **caractérisé en ce qu'**il comprend également une boucle PLL à verrouillage de phase (5) pour fournir une tension d'adaptation (Vtune) à l'oscillateur de référence qui est un oscillateur VCO (4).

8. Récepteur (1) à super réaction selon la revendication 6 **caractérisé en ce que** l'oscillateur de référence (4) fonctionne à une fréquence égale ou supérieure à 2,4 GHz et sans abaissement de fréquences pour des opérations de démodulation.

9. Récepteur (1) à super réaction selon la revendication 6 **caractérisé en ce que** le circuit de génération de courant d'amplification supplémentaire comprend au moins un miroir de courant constitué d'un premier transistor de type NMOS (M13) et d'un second transistor de type NMOS (14), le premier transistor NMOS (M13) ayant sa borne de source liée à la masse et la borne de grille et la borne de drain liées ensemble pour être liées à une seconde source de courant (12), le second transistor NMOS (M14) ayant sa borne de grille reliée à la borne de grille du premier transistor NMOS (M13), sa borne de source liée à la masse et la borne de drain fournissant le courant d'amplification supplémentaire (iboost) à l'oscillateur de référence (4).

10. Récepteur (1) à super réaction selon la revendication 9 **caractérisé en ce que** le circuit de génération de courant d'amplification supplémentaire destiné à être activé après la détection de la première oscillation comprend un détecteur d'amplitude (M11, M12) relié au miroir de courant (M13, M14) pour la fourniture du courant d'amplification supplémentaire (iboost) pour l'oscillateur de référence (4), le premier détecteur d'amplitude comprenant un premier transistor NMOS (M11) et un second transistor NMOS (M12), le premier transistor NMOS (M11) étant branché de manière identique au premier transistor NMOS (M13) du miroir de courant en étant reliée à une première source de courant (11), et le second transistor NMOS (M12), la borne de drain du second transistor NMOS (M12 ) étant reliée à la grille et au drain du premier transistor NMOS (13) du miroir de courant.

11. Récepteur (1) à super réaction selon la revendication 10 **caractérisé en ce que** les transistors NMOS (M11, M12) du détecteur d'amplitude sont de même taille et polarisés en faible inversion, alors que les transistors NMOS (M13, M14) du miroir de courant sont deux transistors NMOS polarisés en forte inversion.

## Patentansprüche

1. Verfahren zur Verbesserung der Detektion der Einschaltzeit eines Referenz-Oszillators (4) eines Superreaktionsempfängers (1), wobei der Empfänger (1) den Referenzoszillator (4), einen Polarisationsstromgenerator (7) zur Bereitstellung eines Polarisationsstroms (i_vco) an den Referenzoszillator (4) unmittelbar nach dem Empfang von mindestens einem Aktivierungssteuersignal (Sosc), einen Oszillationsdetektor (6), der zwischen einem Eingang oder Ausgang (coilp) des Referenzoszillators (4) und dem Vorspannstromgenerator (7) angeschlossen ist, um eine Oszillation im Referenzoszillator (4) zu detektieren, sowie eine Impedanzanpassungseinheit (3), die zwischen einer Anschlussklemme oder einem Pad (2) zum Empfangen eines HF-Signals des Empfängers (1) und dem Referenzoszillator (4) angeordnet ist, umfasst,
wobei der der Oszillationsdetektor (6) nach dem Bereitstellen des Vorspannstroms (i_vco) nach Empfangen des Aktivierungssteuersignals (Sosc) eine erste Schwingung des Referenzoszillators (4) detektiert, und wobei, sobald die Schwingung detektiert wird, ein zusätzlicher Verstärkungsstrom (i_boost), der von der Hüllkurve der durch eine Verstärkungsstrom-Erzeugungsschaltung detektierten Schwingung abhängt, dem Referenzoszillator (4) zusätzlich zum Vorspannstrom zugeführt wird, um das Oszillationssignal so zu verstärken, dass es oberhalb eines kritischen Einschwing-Schwellwerts liegt, wodurch der Aktivierungszeitpunkt des Oszillators präzise definiert wird,
wobei bei jedem Aktivierungssteuerungssignal (Sosc), das dem Polarisationsstromgenerator (7) bereitgestellt wird, ein Polarisationsstrom progressiv ansteigt und mindestens einen kritischen Stromwert erreicht, ab dem die Schwingung des Referenzoszillators (4) beginnt, insofern der Oszillationsdetektor (6) die erste Schwingung des Referenzoszillators (4) detektiert, und **dadurch gekennzeichnet, dass** bei der
zweiten Schwingung, die durch den Oszillationsdetektor (6) detektiert wird, ein Abschaltsteuersignal (stop) dem Polarisationsstromgenerator (7) sowie dem Stromkreis zur Erzeugung eines zusätzlichen Verstärkungsstroms übermittelt wird, um die Stromzufuhr zum Referenzoszillator (4) sofort zu unterbrechen, ihn sofort zu stoppen und so den Stromverbrauch des Empfängers zu verringern.

2. Verfahren nach Anspruch 1, **dadurch gekennzeichnet, dass** der Polarisationsstrom (i_vco) dem Referenzoszillator (4) insbesondere nach dem Empfangen jedes Aktivierungs-Steuersignals (Sosc) innerhalb der Zeit eines Aktivierungs-Steuerzyklus (Sosc) des Polarisationsstromgenerators (7) zugeführt wird.

3. Verfahren nach Anspruch 2, **dadurch gekennzeichnet, dass** das Aktivierungssteuerungssignal (Sosc) über einen Zeitraum von 1 ps beginnt und dass über eine Sekunde ungefähr 1000 Phasen der Aktivierungssteuerung (Sosc) eines Zyklus von aufeinanderfolgenden Steuersignalen (Sosc) so berechnet werden können, dass der Empfänger (1) in einer Sekunde insgesamt nur 1 ms lang eingeschaltet ist.

4. Verfahren nach einem der vorstehenden Ansprüche, bei dem der Empfänger (1) noch eine phasenverriegelte PLL-Schleife (5) aufweist, **dadurch gekennzeichnet, dass** im Laufe der Zeit dem Referenzoszillator, der ein VCO-Oszillator (4) ist, eine Anpassungsspannung (Vtune) zur Anpassung der Oszillationsfrequenz zugeführt wird.

5. Verfahren nach einem der vorstehenden Ansprüche, **dadurch gekennzeichnet, dass** der Polarisationsstromgenerator (7) durch mindestens ein Aktivierungssteuerungssignal nach dem Empfangen eines RF-Signals aktiviert wird.

6. Superreaktionsempfänger (1), konfiguriert für die Anwendung des Verfahrens zum Verbessern der Detektion der Einschaltzeit eines Referenzoszillators (4) eines Superreaktionsempfängers (1) nach einem der vorhergehenden Ansprüche, wobei der Empfänger den Referenzoszillator (4), einen Polarisationsstromgenerator (7) zum Bereitstellen eines Polarisationsstroms (i_vco) an den Referenzoszillator (4) ab dem Erhalten mindestens eines Aktivierungs-Befehlssignals (Sosc), einen Oszillationsdetektor (6), der zwischen einem Eingang oder Ausgang (coilp) des Referenzoszillators (4) und dem Polarisationsstromgenerator (7) zum Detektieren einer Schwingung im Referenzoszillator (4) angeschlossen ist, und eine Impedanzanpassungseinheit (3) zwischen einer Empfangsklemme oder einem Pad (2) für ein RF-Signal des Empfängers (1) und dem Referenzoszillator (4) umfasst, wobei der Empfänger (1) einen zusätzlichen Stromerzeugungskreis umfasst, um einen zusätzlichen Verstärkerstrom (iboost) zum Referenzoszillator (4) zusätzlich zum Polarisationsstrom nach einer ersten durch den Oszillationsdetektor (6) detektierten Schwingung zu liefern, wobei ein zusätzlicher Verstärkerstrom (iboost) zusätzlich zum Polarisationsstrom dem Referenzoszillator (4) zugeführt wird, um das Schwingungssignal zu verstärken, sodass es über einer kritischen Schwelle des Schwingungsbeginns liegt, um die Einschaltzeit des Oszillators genau festzulegen, und es dem Oszillationsdetektor (6) ermöglicht, das Anhalten des Referenzoszillators (4) bei einer zweiten durch den Oszillationsdetektor (6) detektierten Schwingung zu steuern.

7. Superreaktionsempfänger (1) nach Anspruch 6, **dadurch gekennzeichnet, dass** er ebenfalls eine PLL-Schleife mit Phasenverriegelung (5) umfasst, um dem Referenzoszillator, der ein VCO-Oszillator (4) ist, eine Anpassungsspannung (Vtune) zuzuführen.

8. Superreaktionsempfänger (1) nach Anspruch 6, **dadurch gekennzeichnet, dass** der Referenzoszillator (4) mit einer Frequenz von 2,4 GHz oder mehr und ohne Absenkung der Frequenzen für Demodulationsarbeiten arbeitet.

9. Superreaktionsempfänger (1) nach Anspruch 6, **dadurch gekennzeichnet, dass** die Schaltung zur Erzeugung des zusätzlichen Verstärkungsstroms mindestens einen Stromspiegel umfasst, der aus einem ersten Transistor vom NMOS-Typ (M13) und einem zweiten Transistor vom NMOS-Typ (M14) besteht, wobei der erste NMOS-Transistor (M13) eine mit Masse verbundene Source-Klemme aufweist und seine Gate- und Drain-Klemmen miteinander verbunden sind, um mit einer zweiten Stromquelle (12) verbunden zu werden, und wobei der zweite NMOS-Transistor (M14) eine Gate-Klemme aufweist, die mit der Gate-Klemme des ersten NMOS-Transistors (M13) verbunden ist, eine mit Masse verbundene Source-Klemme hat und seine Drain-Klemme den zusätzlichen Verstärkungsstrom (i_boost) an den Referenzoszillator (4) liefert.

10. Superreaktionsempfänger (1) nach Anspruch 9, **dadurch gekennzeichnet, dass** die Schaltung zur Erzeugung des zusätzlichen Verstärkungsstroms, die nach der Detektion der ersten Schwingung aktiviert werden soll, einen Amplitudendetektor (M11, M12) umfasst, der mit dem Stromspiegel (M13, M14) verbunden ist, um den zusätzlichen Verstärkungsstrom (iboost) für den Referenzoszillator (4) bereitzustellen, wobei der erste Amplitudendetektor einen ersten NMOS-Transistor (M11) und einen zweiten NMOS-Transistor (M12) umfasst, wobei der erste NMOS-Transistor (M11) in identischer Weise wie der erste NMOS-Transistor (M13) des Stromspiegels verschaltet ist, indem er mit einer ersten Stromquelle (11) verbunden ist, und dem zweiten NMOS-Transistor (M12), wobei die Drain-Klemme des zweiten NMOS-Transistors (M12) mit der Gate- und der Drain-Klemme des ersten NMOS-Transistors (M13) des Stromspiegels verbunden ist.

11. Superreaktionsempfänger (1) nach Anspruch 10, **dadurch gekennzeichnet, dass** die NMOS-Transistoren (M11, M12) des Amplitudendetektors dieselbe Größe aufweisen und im Bereich der schwachen Inversion betrieben werden, während die NMOS-Transistoren (M13, M14) des Stromspiegels zwei NMOS-Transistoren sind, die im Bereich der starken Inversion betrieben werden.

## Claims

1. Method for enhancing the detection of the start time of a reference oscillator (4) of a super-regenerative receiver (1), the receiver (1) comprising the reference oscillator (4), a bias current generator (7) for supplying a bias current (i_vco) to the reference oscillator (4) on receiving at least one activation control signal (Sosc), an oscillation detector (6) connected between an input or an output (coilp) of the reference oscillator (4) and the bias current generator (7) for detecting an oscillation in the reference oscillator (4), and an impedance matching unit (3) disposed between a terminal or pad (2) for receiving an RF signal of the receiver (1) and the reference oscillator (4),
following the supply of the bias current (i_vco) after receiving the activation control signal (Sosc), the oscillation detector (6) detect a first oscillation of the reference oscillator (4) and as soon as oscillation is detected, an additional amplification current (iboost) dependent on the envelope of the oscillation detected by an amplification current generation circuit is supplied to the reference oscillator (4) in addition to the bias current to amplify the oscillation signal to be above a critical oscillation start threshold so as to precisely define the oscillator start-up time, ,
at each activation control signal (Sosc) supplied to the bias current generator (7), a bias current which increases progressively until at least one critical current value is attained from which the oscillation of the reference oscillator (4) starts, in that the oscillation detector (6) detects the first oscillation of the reference oscillator (4), and **characterised in that** at the second oscillation detected by the oscillation detector (6) a stop control signal (stop) is supplied to the bias current generator (7), as well as an additional amplification current generation circuit for immediately cutting off the supply of the currents to the reference oscillator (4) to stop it immediately and thus reduce the electricity consumption of the receiver.

2. Method according to claim 1, **characterised in that** the bias current (i_vco) is supplied to the reference oscillator (4) particularly after receiving each activation control signal (Sosc) over the time of a cycle of activation control signals (Sosc) of the bias current generator (7).

3. Method according to claim 2, **characterised in that** the activation control signal (Sosc) starts over a period of 1 µs and that over one second, close to 1000 activation control periods (Sosc) of a cycle of successive control signals (Sosc) can be counted such that the receiver (1) is only fully engaged for 1 ms out of one second.

4. Method according to one of the preceding claims, for which the receiver (1) further comprises a PLL phase lock loop (5), **characterised in that** over time, a tuning voltage (Vtune) is supplied to the reference oscillator, which is a VCO oscillator (4) for tuning the oscillation frequency.

5. Method according to one of the preceding claims, **characterised in that** the bias current generator (7) is activated by at least one activation control signal after receiving an RF signal.

6. Super-regenerative receiver (1) configured for implementing the method for enhancing the detection of the start time of a reference oscillator (4) of a super-regenerative receiver (1) according to one of the preceding claims, the receiver comprising the reference oscillator (4), a bias current generator (7) for supplying a bias current (i_vco) to the reference oscillator (4) on receiving at least one activation control signal (Sosc), an oscillation detector (6) connected between an input and an output (coilp) of the reference oscillator (4) and the bias current generator (7) for detecting an oscillation in the reference oscillator (4), and an impedance matching unit (3) disposed between a terminal or pad (2) for receiving an RF signal of the receiver (1) and the reference oscillator (4), the receiver (1) comprising an additional amplification current generation circuit for supplying an additional amplification current (iboost) to the reference oscillator (4) in addition to the bias current after a first oscillation detected by the oscillation detector (6), an additional amplification current (iboost) being supplied to the reference oscillator (4) in addition to the bias current to amplify the oscillation signal to be above a critical oscillation start threshold so as to precisely define the start time of the oscillator, and enable the oscillation detector (6) to order the stoppage of the reference oscillator (4) during a second oscillation detected by the oscillation detector (6).

7. Super-regenerative receiver (1) according to claim 6, **characterised in that** it also comprises a PLL phase lock loop (5) for supplying a tuning voltage (Vtune) to the reference oscillator which is a VCO oscillator (4).

8. Super-regenerative receiver (1) according to claim 6, **characterised in that** the reference oscillator (4) operates at a frequency equal to or greater than 2.4 GHz and without lowering frequencies for demodulation operations.

9. Super-regenerative receiver (1) according to claim 6, **characterised in that** the additional amplification current generation circuit comprises at least one current mirror composed of a first NMOS type transistor (M13) and a second NMOS type transistor (14), the first NMOS transistor (M13) having the terminal thereof connected to the ground and the gate terminal and drain terminal connected together to be connected to a second current source (12), the second NMOS transistor (M14) having the gate terminal thereof connected to the gate terminal of the first NMOS transistor (M13), the source terminal thereof connected to the ground and the drain terminal supplying the additional amplification current (iboost) to the reference oscillator (4).

10. Super-regenerative receiver (1) according to claim 9, **characterised in that** the additional amplification current generation circuit intended to be activated after detecting the first oscillation comprises an amplitude detector (M11, M12) connected to the current mirror (M13, M14) for supplying the additional amplification current (iboost) for the reference oscillator (4), the first amplitude detector comprising a first NMOS transistor (M11) and a second NMOS transistor (M12), the first NMOS transistor (M11) being connected identically to the first NMOS transistor (M13) of the current mirror while being connected to a first current source (11), and the second NMOS transistor (M12), the drain terminal of the second NMOS transistor (M12) being connected to the gate and to the drain of the first NMOS transistor (13) of the current mirror.

11. Super-regenerative receiver (1) according to claim 10, **characterised in that** the NMOS transistors (M11, M12) of the amplitude detector are of the same size and polarised in weak inversion, while the NMOS transistors (M13, M14) of the current mirror are two NMOS transistors polarised in strong inversion.
